(19) Europäisches Patentamt / European Patent Office / Office européen des brevets

(11) **EP 2 838 202 A1**

(12) **EUROPEAN PATENT APPLICATION**

(43) Date of publication:
18.02.2015 Bulletin 2015/08

(51) Int Cl.:
*H03M 1/50* (2006.01)

(21) Application number: 13306155.6

(22) Date of filing: 16.08.2013

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ALCATEL LUCENT**
**92100 Boulogne-Billancourt (FR)**

(72) Inventors:
• **Yu, Xin**
**70435 Stuttgart (DE)**
• **Maier, Simone**
**70435 Stuttgart (DE)**
• **Haslach, Christoph**
**70435 Stuttgart (DE)**
• **Markert, Daniel**
**70435 Stuttgart (DE)**

(74) Representative: **Kleinbub, Oliver et al**
**Alcatel-Lucent Deutschland AG**
**Lorenzstr. 10**
**70435 Stuttgart (DE)**

(54) **A method for pulse width modulation of a radio frequency signal, and a signal processing unit therefor**

(57) The invention concerns a method for pulse width modulation of a radio frequency signal (S), wherein the radio frequency signal (S) is pulse width modulated using a non-ideal reference signal (SR) for the pulse width modulation resulting in a pulse width modulated radio frequency signal (SPWM), the pulse width modulated radio frequency signal (SPWM) is downconverted resulting in a baseband signal (*y*), and distortions of the baseband signal (*y*) due to at least the non-ideal reference signal (SR) are compensated resulting in a compensated base-band signal (*x*), and a signal processing unit therefor.

Fig. 4

EP 2 838 202 A1

**Description**

**Field of the invention**

The invention relates to a method for pulse width modulation of a radio frequency signal, and a signal processing unit adapted to perform said method.

**Background**

The receiver and feedback signal path of a future wireless communication system have to cope with various signal standards, as e.g. Universal Mobile Telecommunications System (UMTS) or 3GPP Long Term Evolution (LTE), as well as different frequency bands. Preferably the receiver should be tuneable in frequency and receive non-contiguous multi-carrier signals simultanously, and should have simple architecture and low power consumption. In order to achieve this goal, an analogue-to-digital-converter (ADC) directly in the radio frequency (RF) domain is needed to convert the analogue RF signal directly into a digital signal as close to the receiving antenna as possible to simplify the frequency tunability. A very promising ADC architecture based on a pulse width modulator (PWM) provides the above mentioned advantages of an RF ADC.

Unforturnately, the ideal reference signal of an ideal pulse width modulator with high frequencies in the RF domain is a triangle wave which is difficult to generate. Instead of using triangle wave as reference signal, one is able to apply a sinusoidal wave at the fundamental frequency of the triangle wave. However, the sinusoidal PWM ADC introduces significant nonlinearity in the signal path, which would result in immense error vector magnitude (EVM) and bit error rate (BER) of the received signal.

**Summary**

A pre-compensation approach may be applied to compensate the nonlinearity of a pulse width modulator in a transmitter. However, in a receiver it is very difficult to pre-compensate the RF signal before the pulse width modulator.

The object of the invention is thus to propose a method for pulse width modulation of a radio frequency signal with a high signal quality, low error vector magnitude (EVM) and low bit error rate (BER) of the received signal, and at the same time with low complexity of the receiver.

The basic idea of the invention is to use non-ideal reference signals for pulse width modulation, which can be easier generated than ideal reference signals, and to compensate distortions caused by the non-ideal reference signals after the pulse width modulation allowing a performance improvement due to an icreased linearity. Since the distortion of a PWM ADC depends in theory monotonically on the envelope signal of the RF signal as well as on the peak of the reference sinusoidal waveform, one is able to determine the distortion by means of the reference signal and the distorted envelope signal of the RF signal. Therefore, one can easily compensate the distortion by multiplying a value depending on the distorted envelope signal cancelling the distortion introduced by the pulse width modulator. In general, the idea is to say, that deterministic distortions, e.g. introduced by a pulse width modulator, can be compensated after the pulse width modulator.

The object is thus achieved by a method for pulse width modulation of a radio frequency signal, wherein

- the radio frequency signal is pulse width modulated using a non-ideal reference signal for the pulse width modulation resulting in a pulse width modulated radio frequency signal,

- the pulse width modulated radio frequency signal is downconverted resulting in a baseband signal,

- and distortions of the baseband signal due to at least the non-ideal reference signal are compensated resulting in a compensated baseband signal.

The object is furthermore achieved by a signal processing unit, e.g. comprised in a receiver or a feedback path of a transmitter, comprising at least one pulse width modulator, at least one downconverter, and at least one compensation unit, wherein

- the at least one pulse width modulator is adapted to use a non-ideal reference signal for pulse width modulation of a radio frequency signal,

- the at least one downconverter is adapted to downconvert a pulse width modulated radio frequency signal resulting in a baseband signal,

- and the at least one compensation unit is adapted to compensate distortions of the baseband signal due to at least the non-ideal reference signal resulting in a compensated baseband signal.

A base station or a user terminal in a wireless communication system can comprise such a signal processing unit in a receiver and/or in a feedback path of a transmitter.

Further applications of pulse width modulators apart from usage in a receiver in a wireless communication system comprise a receiver in a control unit of the supply of electrical power for other devices such as in speed control of electric motors, operation of so-called class-D audio switching amplifiers or brightness control of light sources.

In the following the description focuses on binary, i.e. 2-level, pulse width modulators. However, this does not represent a limitation of the invention as presented below. The invention is applicable to binary, ternary and multi level pulse width modulators in general.

Further features and advantages are stated in the following description of exemplary embodiments, with reference to the figures, which show significant details, and are defined by the claims. The individual features can be implemented individually by themselves, or several of them can be implemented in any desired combination.

**Brief description of the figures**

In the following the invention will be explained further making reference to the attached drawings.

Fig. 1 schematically shows a pulse width modulator according to the state of the art.

Fig. 2 schematically shows an input signal with a continuous amplitude, an output signal and a sawtooth reference signal of a pulse width modulator according to the state of the art.

Fig. 3 schematically shows a signal path in a receiver with a triangle wave reference signal of a pulse width modulator, and a signal path in a receiver with a sinusoidal reference signal of a pulse width modulator.

Fig. 4 schematically shows a signal path in a receiver with a sinusoidal reference signal of a pulse width modulator and with a post-compensation scheme of distortions due to the sinusoidal reference signal of the pulse width modulator according to an embodiment of the invention.

Fig. 5 schematically shows details of a post-compensation scheme for compensation of distortions due to a sinusoidal reference signal of a pulse width modulator according to an embodiment of the invention.

Fig. 6 schematically shows spectra of a pulse width modulated signal in a digital domain.

Fig. 7 schematically shows a downconverted pulse width modulated signal in a digital domain before and after post-compensation according to an embodiment of the invention.

**Description of the embodiments**

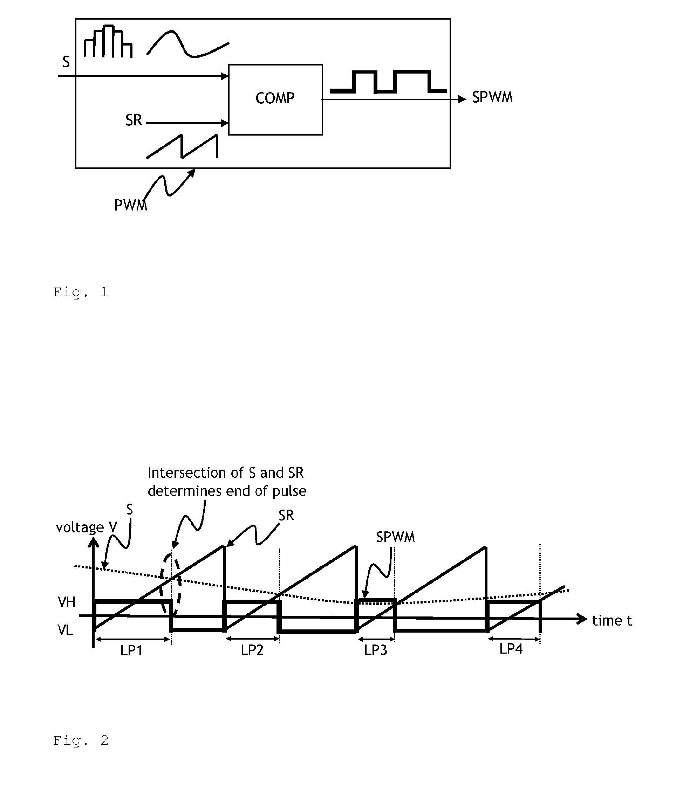

Fig. 1 schematically shows a pulse width modulator PWM according to the state of the art comprising as a basic part a comparator COMP with two inputs and one output.

Depending on the implementation, the input signal S of the pulse width modulator PWM can either be a signal with continuous amplitude, or the sampled version of the continuous amplitude signal, sampled at equidistant or non equidistant time instances.

The input signal S is fed to the first input of the comparator COMP, and a sawtooth signal SR is fed as reference signal to the second input of the comparator COMP. As soon as the ascending amplitude of the sawtooth signal SR has the same value as the input signal S, the output of the comparator switches from voltage-high (VH) to voltage-low (VL) and remains at VL as long as $SR \geq S$ holds. As soon as the descending amplitude of the sawtooth signal SR has the same value as the input signal S, the output of the comparator switches from voltage-low (VL) to voltage-high (VH) and remains at VH as long as $SR < S$ holds. The pulse width modulated signal SPWM is transmitted from the output of the comparator COMP to the output of the pulse width modulator PWM.

Fig. 2 schematically shows such an input signal S, an output signal SPWM and a sawtooth signal SR of a pulse width modulator according to the state of the art as depicted in fig. 1.

In the diagram in fig. 2, the voltage V of a continuous amplitude input signal S, a pulse width modulated output signal SPWM and a sawtooth signal SR are plotted against the time t.

As soon as the ascending amplitude of the sawtooth signal SR has the same value as the continuous amplitude input signal S, the output of the comparator COMP in fig. 1 switches from voltage-high VH to voltage-low VL. As soon as the descending amplitude of the sawtooth signal SR has the same value as the input signal S, the output of the comparator COMP switches from voltage-low (VL) to voltage-high (VH). The output signal of the comparator COMP is the pulse width modulated signal SPWM comprising pulses of different length LP1-LP4. Furthermore, pulse width modulators based on similar principles, such as single-edge pulse width modulators, are not described here,but the proposed post compensation method can be used for all of these pulse width modulators.

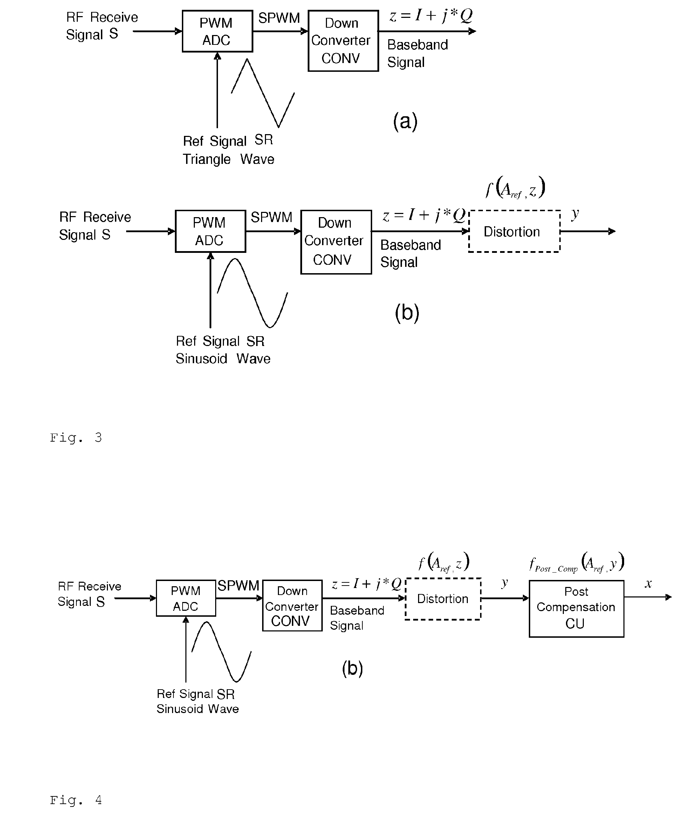

Fig. 3 schematically shows a signal path in a receiver with a triangle wave reference signal of a pulse width modulator, and a signal path in a receiver with a sinusoidal reference signal of a pulse width modulator.

In Fig. 3(a), an ideal pulse width modulator analogue to digital converter PWM ADC with a reference signal of a triangle wave connected to a down-converter CONV is presented. An RF input signal S is pulse width modulated in the pulse width modulator analogue to digital converter PWM ADC using the triangle wave as reference signal resulting in a pulse width modulated digital binary signal SPWM. Subsequently the pulse width modulated digital binary signal SPWM is sampled and then downconverted in the down-converter CONV to a digital baseband signal $z=I+i*Q$, which is composed of so-called I- and Q-components , by using a classical mixer and a low pass finite impulse response (FIR) filter. In an alternative, one is also able to sample the baseband signal after downconversion.

As already mentioned above, an ideal triangle wave is difficult to generate, and thus, in most existing applications a sinusoid is used as a reference signal instead of a triangle wave, as e.g. shown in Fig. 3(b).

In Fig. 3(b), an ideal pulse width modulator analogue to digital converter PWM ADC with a reference signal of a sinusoidal wave connected to a down-converter CONV is presented. An RF input signal S is pulse width modulated in the pulse width modulator analogue to digital converter PWM ADC using the sinusoidal wave as reference signal resulting in a pulse width modulated digital binary signal SPWM. Subsequently the pulse width modulated digital binary signal SPWM is down-converted in the down-converter CONV to a distorted digital baseband signal $y=I_{dist}+i*Q_{dist}$, which is composed of distorted so-called I- and Q-components, by using a classical mixer and a low pass finite impulse response (FIR) filter. The distorted digital baseband signal $y$, which is distorted due to the use of a sinusoidal reference signal, is related to the undistorted digital baseband signal z by a baseband distortion function $f(A_{ref}, z)$ as described in the following.

As already mentioned above, the advantage of a non-ideal reference signal SR of simpler signal generation comes at the cost of inband and out-of-band distortions, i.e. lower coding efficiency. Let us consider the sinusoidal reference signal SR(t), with $A_{ref}$ being the magnitude and $f_{ref}$ being the frequency of the sinusoidal reference signal SR(t):

$$SR(t) = A_{ref} \sin\left(2\pi f_{ref} t\right). \tag{1}$$

The distortions introduced by the sinusoidal reference signal SR can be modelled by the equivalent baseband distortion function $f(A_{ref}, z)$, modifying the downconverted baseband signal z. Thus, one can also interpret the distortion occurring at the output signal of an ideal pulse width modulator instead of at the input signal. In Fig. 3(b), the replacement of the triangle wave by a sinusoidal wave for the reference signal introduces a post distortion described by the following baseband distortion function $f(A_{ref}, z)$ after downconversion:

$$f\left(A_{ref}, z\right) = \frac{2}{\pi} A_{ref} \arcsin\left(\frac{|z|}{A_{ref}}\right), \tag{2}$$

where $A_{ref}$ again represents the maximum amplitude, i.e. magnitude, of the reference sinusoid, under the assumption that the amplitude of $Z$ is smaller than $A_{ref}$. Subsequently the received distorted digital baseband signal is given by:

$$y = f\left(A_{ref}, z\right) \cdot e^{(i*angle(z))}. \tag{3}$$

The distortion in the receiver path causes extra immense bit error rate (BER). Since the magnitude of the sinusoidal reference signal $A_{ref}$ and the amplitudes of the distorted samples $y$ are known, one is able to calculate the distortion and multiply the distorted baseband signal $y$ with a value cancelling the distortion introduced by the pulse width modulator, as e.g. shown in fig. 4.

Fig. 4 schematically shows a signal path in a receiver with a sinusoidal reference signal of a pulse width modulator and with a post-compensation scheme of distortions due to the sinusoidal reference signal of the pulse width modulator according to an embodiment of the invention.

In fig. 4, an ideal pulse width modulator analogue to digital converter PWM ADC with a reference signal of a sinusoidal wave connected to a downconverter CONV is presented. An RF input signal S is pulse width modulated in the pulse width modulator analogue to digital converter PWM ADC using the sinusoidal wave as reference signal resulting in a pulse width modulated digital binary signal SPWM. Subsequently the pulse width modulated digital binary signal SPWM is down-converted in the down-converter CONV to a distorted digital baseband signal $y=I_{dist}+i*Q_{dist}$, which is composed of distorted so-called I- and Q-components, by using a classical mixer and a low pass finite impulse response (FIR) filter. The distorted digital baseband signal $y$, which is distorted due to the use of a sinusoidal reference signal, is related to the undistorted digital baseband signal z by a baseband distortion function $f(A_{ref},z)$ as depicted in fig. 3(b) and described above. The distorted digital baseband signal $y$ is then sent to a post compensation unit CU, in which the distorted digital baseband signal $y$ is multiplied with a compensation function $f_{Post\_Comp}(A_{ref},y)$ cancelling the distortion introduced by the pulse width modulator analogue to digital converter PWM ADC. Said post compensation results in a compensated baseband signal $x$.

The compensated baseband signal $x$ can be expressed as:

$$x = f_{Post\_Comp}\left(A_{ref}, y\right) \cdot e^{(i*angle(y))} = z \qquad (4)$$

with

$$f_{Post\_Comp}\left(A_{ref}, f\left(A_{ref}, x\right)\right) = K \qquad (5)$$

and

$$f_{Post\_Comp}\left(A_{ref}, y\right)/K = f^{-1}\left(A_{ref}, x\right), \qquad (6)$$

and $K$ indicating a constant.

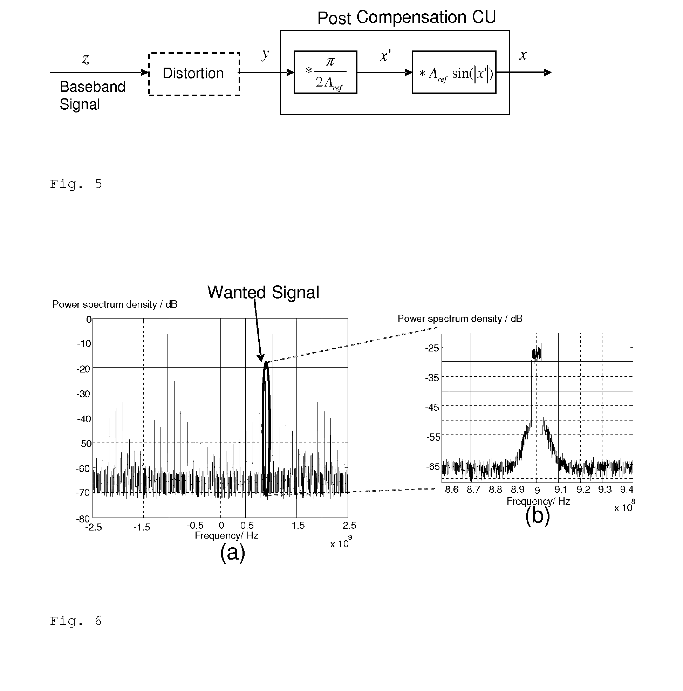

Fig. 5 schematically shows details of such a post compensation scheme for compensation of distortions due to a sinusoidal reference signal of a pulse width modulator according to an embodiment of the invention.

The distorted baseband signal $y$ is first multiplied with a constant $\dfrac{\pi}{2A_{ref}}$ in the post compensation unit CU, resulting in an intermediate baseband signal $x'$:

$$x'= y * \frac{\pi}{2A_{ref}} = \arcsin\left(\frac{|z|}{A_{ref}}\right) * e^{(i*angle(z))} . \qquad (7)$$

Then, the intermediate baseband signal $x'$ is multiplied with a factor $A_{ref}*sin(x')$, and at the end, the compensated baseband signal $x$ is given by the following formula:

$$x = A_{ref} * \sin\left(x'\right) * e^{(i*angle(y))} = z . \qquad (8)$$

All in all, the post compensation function $f_{Post\_comp}(A_{ref},y)$ can be represented as:

$$f_{Post\_Comp}\left(A_{ref}, y\right) = A_{ref} * \sin\left(\frac{|y| * \pi}{2A_{ref}}\right) . \qquad (9)$$

In an embodiment of the invention, the post compensation function in equation (9) is approximated via one or more lookup tables (LUT) or a linear combination of some basic functions such as polynomial functions. Naturally one needs multiple LUTs and different coefficients of polynomials for different magnitudes $A_{ref}$ of the sinusoidal reference signal SR, which is rarely changed in practical applications.

Furthermore, the receive signal path is not ideal as well. Thus, in a further embodiment of the invention, a post compensation function estimated by a calibration method is used to compensate the nonlinearity of the pulse width modulator analogue to digital converter PWM ADC and the imperfection of the receive signal path. By feeding a known test signal through the receive signal path, one can compare the received distorted baseband test signal $y$ with the ideal undistorted test signal on baseband level to estimate the nonlinear behaviour of the receiver including the sinusoidal reference signal of the pulse width modulator analogue to digital converter PWM ADC.

It is worthwhile to point out, that the amplitude maximum of the received RF input signal S should be smaller than or equal to the maximum amplitude, i.e. magnitude, $A_{ref}$ of the sinusoidal reference signal for use of the fixed compensation function given in equation (9). Otherwise the distortion of the pulse width modulator analogue to digital converter PWM ADC can not be described by a conventional function. However, one can still compensate the nonlinearity by using a calibration method as described above. For the calibration we only need a training signal which covers the predefined pulse width modulator analogue to digital converter PWM ADC input power range to learn e.g. the coefficients of polynomials or lookup table entries. After calibration of the transfer function between the input of the pulse width modulator analogue to digital converter PWM ADC and the output of the downconverter CONV, the post compensation unit CU is static, as it is assumed that there is no need to use adaptive calibration. However, if the transfer function between the input of the pulse width modulator analogue to digital converter PWM ADC and the output of the downconverter CONV does change during operating time, an adaptive optimisation is also possible. One can rescale the input signal $y$ of the post compensation unit CU by multiplying a factor and then, one can evaluate the compensated baseband signal $x$ in frequency domain and one can check, whether the adjacent channel power (ACP) is smaller or not. In this way one can blindly tune the factor to minimize the adjacent channel power (ACP) caused by a nonlinearity of the pulse width modulator analogue to digital converter PWM ADC.

In the following, the achieved signal improvement in hardware tests due to the above-described post compensation scheme is disclosed. The test-setup is basically composed of an RF signal source, connected to an RF pulse width modulator analogue to digital converter with an 1-bit comparator, which is in turn connected to a demultiplexer, which is in turn connected to a field programmable gate array (FPGA). Since the bit rate of the used FPGA evaluation board is about 5Gbit/S, the rate is quadruplicated by a demultiplexer which has four outputs for connections with the field programmable gate array (FPGA). The FPGA captures the pulse width modulated binary signal in RF domain and transmits the received signal to a PC for signal processing, as e.g. downconversion.

Fig. 6 schematically shows a power density in dB depicted over a frequency in Hz of a pulse width modulated binary signal resulting from the above-described hardware tests without application of a post compensation scheme according to an embodiment of the invention.

Fig. 6(a) shows the pulse width modulated binary signal over a wide frequency range, whereas fig. 6(b) shows a zoomed in spectrum of the pulse width modulated binary signal. In the zoomed subfigure (b) one can observe the wanted signal at 900MHz with relative high adjacent channel power (ACP) due to the nonlinear behavior of the sinusoidal reference signal of the pulse width modulator analogue to digital converter. Furthermore, in the hardware test no interference signal has been inserted in the RF source signal.

The sinusoid-like spurious is a harmonic of a clocking of the pulse width modulator analogue to digital converter and the pulse width modulated signal. If interference is located within the receive or observation band, it can be regarded as part of the wanted signal and will not impact the compensation performance when applying a post compensation scheme according to an embodiment of the invention, but will affect the dynamic range as conventional analogue to digital converter. The interference out of the observation band can deteriorate the compensation performance. However it can be filtered by a receive filter before the pulse width modulator analogue to digital converter.

In hardware experiments, a first method of post compensation using a post compensation function as depicted in fig. 5 and described above, and a second method of post compensation using a calibration method as described above were tested. The results are presented in table 1 below. Error vector magnitudes (EVMs) are calculated with and without post compensation.

In the first column of table 1, it is indicated whether the maximum amplitude of the RF input signal RF_max_amplitude is smaller or bigger than the maximum amplitude of the sinusoidal reference signal $A_{ref}$. The entries in the first column of table 1 shall have an increasing order of the ratio RF_max_amplitude / $A_{ref}$.

In the second column of table 1, the calculated EVMs of baseband signals without post compensation are given for the downwards increasing ratios RF_max_amplitude /$A_{ref}$.

In the third column of table 1, the calculated EVMs of baseband signals with post compensation using a post compensation function as depicted in fig. 5 and described above are given for the downwards increasing ratios RF_max_amplitude / $A_{ref}$.

In the fourth column of table 1, the calculated EVMs of baseband signals with post compensation using a calibration method as described above are given for the downwards increasing ratios RF_max_amplitude / $A_{ref}$.

If the maximum amplitude of the RF input signal RF_max_amplitude is smaller than $A_{ref}$, the post compensation method using a post compensation function and the post compensation method using a calibration method provide similar compensation performance in terms of EVM.

Otherwise one can only apply a calibration method to calculate a transfer function or an inverse transfer function of the pulse width modulator analogue to digital converter, and hence perform the post compensation. The remaining EVM after post compensation is caused by white noise, e.g. due to the limited sampling rate for the high speed 1-bit decision, and can not be compensated.

The proposed post compensation method using a calibration method can compensate the dominating nonlinearity of the pulse width modulator analogue to digital converter PWM ADC in the receive path even if the pulse width modulator analogue to digital converter PWM ADC is strongly overdriven by the RF input signal, and the EVM is reduced in this case from 32.3% to 9.02% as can be seen in the last row in table 1.

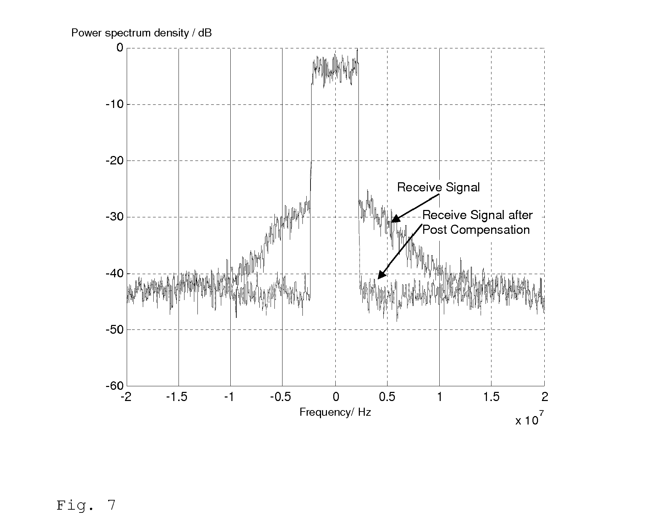

Fig. 7 schematically shows a power density in dB depicted over a frequency in Hz of a downconverted baseband signal in a digital domain before and after post compensation. As can be seen in fig. 7, the ACP of a baseband signal after post compensation has vanished under the noise floor.

Generally, the post compensation scheme exhibit very good compensation performance, namely significantly improve the linearity of the receive signal path with sinusoidal reference signals of the pulse width modulator analogue to digital converter PWM ADC. An even better performance can be expected with an increased sampling rate of the entire hardware test setup.

Table 1: EVM reduction due to post compensation

| Increasing order of the ratio RF_max_amplitude / $A_{ref}$ | EVM (without post compensation) | EVM of post compensation with fixed function | EVM of post compensation with calibration |
|---|---|---|---|
| RF_max_amplitude < $A_{ref}$ | 3.7% | 2.40% | 2.41% |
| RF_max_amplitude > $A_{ref}$ | 7.60% | XXXXXXXXX | 2.59% |
| RF_max_amplitude > $A_{ref}$ | 14.48% | XXXXXXXXX | 2.85% |
| RF_max_amplitude > $A_{ref}$ | 19.20% | XXXXXXXXX | 4.35% |
| RF_max_amplitude >> $A_{ref}$ | 23.70% | XXXXXXXXX | 5.64% |
| RF_max_amplitude >> $A_{ref}$ | 25.79% | XXXXXXXXX | 6.63% |
| RF_max_amplitude >> $A_{ref}$ | 28.73% | XXXXXXXXX | 7.63% |
| RF_max_amplitude >> $A_{ref}$ | 32. 30% | XXXXXXXXX | 9.02% |

**Claims**

1. A method for pulse width modulation of a radio frequency signal (S), wherein

    • the radio frequency signal (S) is pulse width modulated using a non-ideal reference signal (SR) for the pulse width modulation resulting in a pulse width modulated radio frequency signal (SPWM),
    • the pulse width modulated radio frequency signal (SPWM) is downconverted resulting in a baseband signal (*y*),
    • and distortions of the baseband signal (*y*) due to at least the non-ideal reference signal (SR) are compensated resulting in a compensated baseband signal (x).

2. A method according to claim 1, wherein said distortions are compensated in the baseband signal (*y*) by a compensation function ($f_{Post\_Comp}(A_{ref}, y)$) which is dependent on a magnitude ($A_{ref}$) of the non-ideal reference signal (SR) and an amplitude of the baseband signal (*y*).

3. A method according to claim 2, wherein the compensation function ($f_{Post\_Comp}(A_{ref}, y)$) is approximated by one or several lookup tables, each of said lookup tables being applicable for a dedicated magnitude ($A_{ref}$) of the non-ideal reference signal (SR).

4. A method according to claim 2, wherein the compensation function ($f_{Post\_Comp}(A_{ref}, y)$) is approximated by several linear combinations of functions, each of said linear combinations of functions being applicable for a dedicated magnitude ($A_{ref}$) of the non-ideal reference signal (SR).

5. A method according to claim 4, wherein said functions used for said linear combinations of functions are polynomial functions.

6. A method according to any of the preceding claims, wherein the non-ideal reference signal (SR) is a sinusoidal reference signal.

7. A method according to any of the preceding claims, wherein distortions of the baseband signal ($y$) due to the non-ideal reference signal (SR) and at least one of the group of a non-linearity of a pulse width modulator (PWM ADC) and imperfections of a signal path are compensated by a compensation function which is calibrated by feeding a known test signal in the signal path comprising at least the pulse width modulator (PWM ADC) and a downconverter (CONV) and comparing a resulting baseband test signal after the pulse width modulator (PWM ADC) and the downconverter (CONV) with the ideal undistorted test signal on baseband level.

8. A signal processing unit comprising at least one pulse width modulator (PWM ADC), at least one downconverter (CONV), and at least one compensation unit (CU), wherein

   • the at least one pulse width modulator (PWM ADC) is adapted to use a non-ideal reference signal (SR) for pulse width modulation of a radio frequency signal (S),
   • the at least one downconverter (CONV) is adapted to downconvert a pulse width modulated radio frequency signal (SPWM) resulting in a baseband signal ($y$),
   • and the at least one compensation unit (CU) is adapted to compensate distortions of the baseband signal ($y$) due to at least the non-ideal reference signal (SR) resulting in a compensated baseband signal ($x$).

9. A receiver comprising a signal processing unit according to claim 8.

10. A transmitter comprising in a feedback path a signal processing unit according to claim 8.

11. A base station comprising a receiver according to claim 9 or a transmitter according to claim 10.

12. A user terminal comprising a receiver according to claim 9 or a transmitter according to claim 10.

Fig. 1

Fig. 2

RF Receive Signal S $\longrightarrow$ PWM ADC $\xrightarrow{\text{SPWM}}$ Down Converter CONV $\xrightarrow{\quad z = I + j*Q \quad}$ Baseband Signal

Ref Signal SR Triangle Wave

(a)

RF Receive Signal S $\longrightarrow$ PWM ADC $\xrightarrow{\text{SPWM}}$ Down Converter CONV $\xrightarrow{\quad z = I + j*Q \quad}$ Baseband Signal $\longrightarrow$ $f\left(A_{ref}, z\right)$ Distortion $\xrightarrow{\quad y \quad}$

Ref Signal SR Sinusoid Wave

(b)

Fig. 3

RF Receive Signal S $\longrightarrow$ PWM ADC $\xrightarrow{\text{SPWM}}$ Down Converter CONV $\xrightarrow{\quad z = I + j*Q \quad}$ Baseband Signal $\longrightarrow$ $f\left(A_{ref}, z\right)$ Distortion $\xrightarrow{\quad y \quad}$ $f_{Post\_Comp}\left(A_{ref}, y\right)$ Post Compensation CU $\xrightarrow{\quad x \quad}$

Ref Signal SR Sinusoid Wave

(b)

Fig. 4

Post Compensation CU

$$z \quad \xrightarrow{\text{Baseband Signal}} \quad \text{Distortion} \quad \xrightarrow{y} \quad * \frac{\pi}{2 A_{ref}} \quad \xrightarrow{x'} \quad * A_{ref} \sin\left(\left|x'\right|\right) \quad \xrightarrow{x}$$

Fig. 5

Wanted Signal

Power spectrum density / dB

Power spectrum density / dB

(a)

(b)

Fig. 6

Fig. 7

European
Patentamt

European
Patent Office

Office européen
des brevets

**EUROPEAN SEARCH REPORT**

Application Number

EP 13 30 6155

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 608 410 A1 (ALCATEL LUCENT [FR]; UNIV FRIEDRICH ALEXANDER ER [DE]) 26 June 2013 (2013-06-26) <br> * paragraph [0001] * <br> * paragraph [0014] * <br> * paragraph [0036] - paragraph [0057] * <br> * paragraph [0065] - paragraph [0075] * <br> * figures 4-7 * | 1-12 | INV. H03M1/50 |
| A | JAEWOOK KIM ET AL: "Analysis and Design of Voltage-Controlled Oscillator Based Analog-to-Digital Converter", IEEE TRANSACTIONS ON CIRCUITS AND SYSTEMS I: REGULAR PAPERS, IEEE, US, vol. 57, no. 1, 1 January 2010 (2010-01-01), pages 18-30, XP011333596, ISSN: 1549-8328, DOI: 10.1109/TCSI.2009.2018928 <br> * abstract * <br> * page 26 * <br> * figures 16, 17 * | 1-12 | |
| A | NARAGHI S ET AL: "A 9-bit, 14 Î 1/4 W and 0.06 mm<{>2} Pulse Position Modulation ADC in 90 nm Digital CMOS", IEEE JOURNAL OF SOLID-STATE CIRCUITS, IEEE SERVICE CENTER, PISCATAWAY, NJ, USA, vol. 45, no. 9, 1 September 2010 (2010-09-01), pages 1870-1880, XP011317124, ISSN: 0018-9200, DOI: 10.1109/JSSC.2010.2050945 <br> * page 1870 - page 1871 * <br> * figures 1, 2 * | 1-12 | |

TECHNICAL FIELDS SEARCHED (IPC)

H03M

-/--

The present search report has been drawn up for all claims

| Place of search | Date of completion of the search | Examiner |
|---|---|---|
| Munich | 30 October 2013 | Marzenke, Marco |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 13 30 6155

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2006/238398 A1 (KOMURO TAKANORI [JP] ET AL) 26 October 2006 (2006-10-26)<br>* paragraph [0001] *<br>* paragraph [0022] - paragraph [0044] *<br>* figures 1-4 *<br>----- | 1-12 | |

TECHNICAL FIELDS
SEARCHED        (IPC)

The present search report has been drawn up for all claims

| Place of search | Date of completion of the search | Examiner |
|---|---|---|
| Munich | 30 October 2013 | Marzenke, Marco |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.................................................................................................

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 13 30 6155

This annex lists the patent family members relating to the patent documents cited in the above-mentioned European search report.
The members are as contained in the European Patent Office EDP file on
The European Patent Office is in no way liable for these particulars which are merely given for the purpose of information.

30-10-2013

| Patent document cited in search report | | Publication date | Patent family member(s) | Publication date |
|---|---|---|---|---|
| EP 2608410 | A1 | 26-06-2013 | NONE | |
| US 2006238398 | A1 | 26-10-2006 | DE 102006018450 A1 | 26-10-2006 |
| | | | JP 2006304035 A | 02-11-2006 |
| | | | US 2006238398 A1 | 26-10-2006 |

EPO FORM P0459

For more details about this annex : see Official Journal of the European Patent Office, No. 12/82